Europäisches Patentamt

European Patent Office

Office européen des brevets

(19)

(11) Publication number : **0 439 236 B1**

(12) **EUROPEAN PATENT SPECIFICATION**

(45) Date of publication of patent specification :
27.09.95 Bulletin 95/39

(51) Int. Cl.⁶ : **H01S 3/085, H01L 33/00**

(21) Application number : **91200135.1**

(22) Date of filing : **23.01.91**

(54) **Laser structure with distributed feedback and method of manufacturing same.**

(30) Priority : **23.01.90 NL 9000164**

(43) Date of publication of application :
**31.07.91 Bulletin 91/31**

(45) Publication of the grant of the patent :
**27.09.95 Bulletin 95/39**

(84) Designated Contracting States :
**AT BE CH DE DK ES FR GB GR IT LI LU NL SE**

(56) References cited :
**GB-A- 2 151 402
GB-A- 2 209 408
US-A- 4 775 980
US-A- 4 847 857
IEEE JOURNAL OF QUANTUM ELECTRONICS,
vol. 25, no. 10, October 1989, pages 2096-2105,
IEEE, New York, US; A. HARDY et al.:
"Analysis of second-order gratings"**

(73) Proprietor : **INTERUNIVERSITAIR
MICROELEKTRONICA CENTRUM VZW
Kapeldreef 75
B-3030 Leuven-Heverlee (BE)**

(72) Inventor : **Baets, Roeland Gustaaf Frans
Engelhoekstraat 21
B-9800 Deinze (BE)**
Inventor : **Morthier, Geert Jozef Ivo
Groenewandeling 68
B-9031 Gent (BE)**

(74) Representative : **Bruin, Cornelis Willem et al
Arnold & Siedsma,
Advocaten en Octrooigemachtigden,
Sweelinckplein 1
NL-2517 GK Den Haag (NL)**

EP 0 439 236 B1

## Description

Since the article "Coupled-wave theory of distributed feedback lasers" by H. Kogelnik and C.V. Schank in the Journal of Applied Physics, Volume 43, no. 5, May 1972, the trend has been increasingly towards lasers with distributed feedback. These DFB lasers have a power spectrum narrow in wavelength and are suitable for use in optical telecommunication and the like. With these known DFB lasers a wave-like junction or so-called grid is arranged between a first and second cladding layer, whereby distributed Bragg reflections take place between optical waves travelling backward and forward.

With long DFB lasers, which are important for obtaining a narrow line width, problems occur with respect to stability of the mode selectivity thereof. This is the consequence of variation of the power density in the lengthwise direction of the DFB laser.

US-A- 4 847 857 discloses a DFB laser in which the coupling coefficient is lowered in the central portion and is increased near the end surfaces.

The present invention provides a laser structure according to claim 1 and methods of manufacturing the same according to claims 3 and 4.

Particularly at high power, the above is of importance.

Further advantages and features of the details of the present invention will become apparent in the light of a description of preferred embodiments thereof with reference to the annexed drawing, wherein:

Fig. 1 shows a schematic view in section of a first embodiment of a laser structure according to the present invention;

Fig. 2 shows a schematic detail of a second embodiment of a laser structure according to the present invention; and

Fig. 3 shows a schematic view in section of an embodiment according to the present invention.

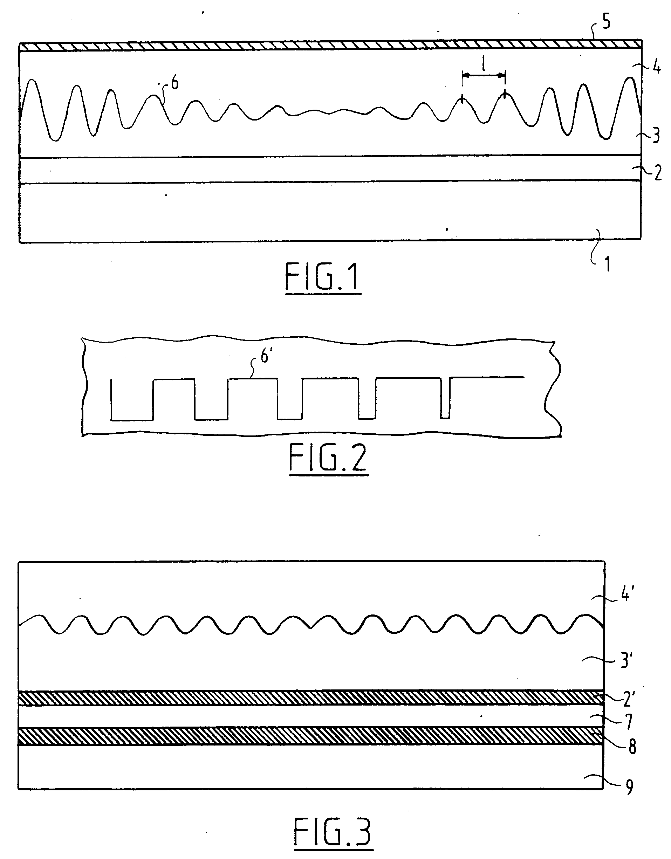

Applied to a substrate 1 (fig. 1), for instance of InP, is an active layer 2, for instance of InGaAsP, onto which is applied a first cladding layer 3, for instance also of InGaAsP with another refractive index, onto which is applied a second cladding layer 4, for instance of InP, on which an electrode 5 is arranged. The refractive indices of the layers 1, 2, 3 and 4 amount for instance to 3.1, 3.5, 3.2 and 3.1 respectively. Arranged between the first and second cladding layers 3 and 4 is a junction 6 provided with a periodic structure the amplitude of which varies in travel direction of the waves in the active layer 2 (i.e. in the lengthwise direction of fig. 2). As a result of the varying amplitude an at least slightly more uniform power density is created in lengthwise direction of the active layer 2 than according to the known art.

In preference the periodic structure is formed such that the coupling coefficient between both waves approaches the following formula:

$$k(z) = \frac{1 - 2z/L}{2[z(L - z)^{0.5}}$$

wherein L is the length of the laser and z the coordinate in lengthwise direction of the laser.

The above mentioned embodiment can be manufactured for instance using holographic techniques; the patterns with mutually slightly differing periodic length dimensions provide the shown junction 6. For a characteristic wavelength of $\lambda$= 1.3-1.6 um a characteristic measurement of the junction 6 amounts for instance to $\lambda$= 0.2 um.

A junction structure 6' to be made preferably with electron beams (fig. 2) has approximately the character of a block shape with varying positive and negative surfaces, similar to a block wave with varying duty cycle.

With a structure as shown in fig. 3 a directional coupling layer 7 is arranged beneath an active layer 2', under which layer 7 a second active layer 8 is arranged above a substrate layer 9. Applied above the active layer 2' is a first cladding layer 3' and a second cladding layer 4', between which is situated a junction with periodic structure of substantially constant amplitude. Due to the coupling layer 7 the coupling coefficient between the wave moving to the left and the wave moving to the right in fig. 3 is varied over the lengthwise direction of active layer 2'. A more uniform power density is also achieved over the length of active layer 2' in this embodiment than is known in the prior art.

## Claims

1. Laser structure with varying distributed feedback, comprising:
   - a substrate;
   - an active layer applied to the substrate;
   - a first cladding layer applied to the active layer;
   - a second cladding layer applied to the first cladding layer; and
   - variation means for variation in coupling coefficient between the wave travelling backward and forward in the active layer, which variation means comprise a periodic structure or grid between the first cladding layer and the second cladding layer, wherein the periodic structure is formed at a position z along the laser structure such that the coupling coefficient k(z) between the wave travelling backward and the wave travelling forward approaches the following formula:

$$k(z) = \frac{1 - 2z/L}{2\sqrt{z(L - z)}}$$

   wherein L is the total length of the laser structure.

2. Laser structure as claimed in claim 1, wherein the variation means comprise a second active layer which is coupled with the first active layer via a directional coupling layer.

3. Method for manufacturing the laser structure as claimed in claim 1, wherein the periodic structure is formed by two holographic interference patterns with mutually differing repetition intervals.

4. Method for manufacturing a laser structure as claimed in claim 1, wherein the periodic structure has the character of a block wave with varying duty cycle arranged by means of electron beams.

## Patentansprüche

1. Laserstruktur mit variierender verteilter Rückkoppelung, mit:
   - einem Substrat;
   - einer an dem Substrat angebrachten aktiven Schicht;
   - einer an der aktiven Schicht angebrachten ersten Mantelschicht;
   - einer an der ersten Mantelschicht angebrachten zweiten Mantelschicht; und
   - einer Variationseinrichtung zum Variieren eines Kopplungskoeffizienten zwischen der in der aktiven Schicht rückwärts und vorwärts laufenden Welle, wobei die Variationseinrichtung eine periodische Struktur oder ein Gitter zwischen der ersten Mantelschicht und der zweiten Mantelschicht aufweist, worin die periodische Struktur an einer Position z entlang der Laserstruktur derart gebildet ist, daß sich der Kopplungskoeffizient k (z) zwischen der rückwärtslaufenden Welle und der vorwärtslaufenden Welle der folgenden Formel annähert:

$$k(z) = \frac{1 - 2z/L}{2\sqrt{z(L-z)}},$$

   worin L die Gesamtlänge der Laserstruktur ist.

2. Laserstruktur nach Anspruch 1, bei der die Variationseinrichtung eine zweite aktive Schicht aufweist, die mit der ersten aktiven Schicht über eine Richtungskopplungsschicht gekoppelt ist.

3. Verfahren zum Herstellen der Laserstruktur nach Anspruch 1, bei dem die periodische Struktur durch zwei holographische Interferenzmuster mit gegenseitig unterschiedlichen Wiederholungsintervallen gebildet wird.

4. Verfahren zum Herstellen einer Laserstruktur nach Anspruch 1, bei dem die periodische Struktur den Charakter einer Blockwelle mit variierendem Arbeitszyklus, die mittels Elektronenstrahlen angeordnet ist, aufweist.

## Revendications

1. Structure laser à réaction distribuée comprenant :
   - un substrat;
   - une couche active appliquée sur le substrat;
   - une première couche de revêtement appliquée sur la couche active;
   - une seconde couche de revêtement appliquée sur la première couche de revêtement; et
   - des moyens de modification servant à modifier le coefficient de couplage entre l'onde se déplaçant dans le sens inverse et l'onde se déplaçant dans le sens direct dans la couche active, lesquels moyens de modification comprennent une structure périodique ou une grille disposée entre la première couche de revêtement et la seconde couche de revêtement, la structure périodique étant formée dans une position z le long de la structure laser de sorte que le coefficient de couplage k(z) entre l'onde se déplaçant en sens inverse et l'onde se déplaçant dans le sens direct se rapproche de la formule suivante :

$$k(z) = \frac{1 - 2z/L}{2\sqrt{z(L-z)}}$$

   dans laquelle L est la longueur totale de la structure laser.

2. Structure laser selon la revendication 1, dans laquelle les moyens de modification comprennent une seconde couche active, qui est couplée à la première couche active par l'intermédiaire d'une couche de couplage directionnel.

3. Procédé pour fabriquer la structure laser selon la revendication 1, dans lequel la structure périodique est formée par deux diagrammes d'interférences holographiques avec des intervalles de répétition qui diffèrent mutuellement.

4. Procédé pour fabriquer une structure laser selon la revendication 1, selon lequel la structure périodique possède le caractère d'une onde en bloc possédant un taux d'impulsions variable, agencé au moyen de faisceaux d'électrons.

FIG.1

FIG.2

FIG.3